# EUROPEAN PATENT APPLICATION

(11) **EP 4 571 929 A1**
(43) Date of publication of application: **18.06.2025**
(21) Application number: 23216902.9
(22) Date of filing: 14.12.2023
(51) Int. Cl.: H01M 10/42, H01M 10/48, H01M 50/209, H01M 50/284, H01M 50/519

(54) **BATTERY MODULE**

(71) Applicant: Samsung SDI Co., Ltd., Yongin-si, Gyeonggi-do 17084 (KR)
(72) Inventor: Gombats, Ilya, 8052 Graz (AT); Walter, Lukas, 8010 Graz (AT)
(74) Representative: Gulde & Partner

(57) **Abstract**

The present disclosure refers to a battery module (1) including a plurality of battery cells (2); a flexible interconnect (10) for providing electrical information of the plurality of battery cells (2) to a battery management unit, wherein the flexible interconnect (10) has an elongated shape in the longitudinal direction of the battery module (1), which defines the longitudinal direction of the flexible interconnect (10), and is affixed to the plurality of one battery cells (2). The flexible interconnect (10) includes at least one stress relief section (20) extending along the longitudinal direction of the battery module (1), the stress relief section (20) includes at least one cutout (23) extending along the longitudinal direction of the flexible interconnect (10), and a plurality of interconnect traces (24) divided from each other by the at least one non-linear cutout (23), the plurality of interconnect traces (24) include a first peripheric interconnect trace (24) forming a recessed portion (25) and a second peripheric interconnect trace (24), opposite to the first interconnect trace (24), forming a protruding portion (26), and a height (b) of the protruding portion (26) in the stress relief section (20) is not larger than a width (aᵢ) of the flexible interconnect (10) neighbouring the stress relief section (20).

## Description

### Field of the Disclosure

The present disclosure relates to a battery module and a battery pack for accommodating a swelling of battery cells.

### Technological Background

Recently, vehicles for transportation of goods and people have been developed that use electric power as a source for motion. Such an electric vehicle is an automobile that is propelled by an electric motor, using energy stored in rechargeable batteries. An electric vehicle may be solely powered by batteries or may be a form of hybrid vehicle powered by, for example, a gasoline generator or a hydrogen fuel power cell. A hybrid vehicle may include a combination of an electric motor and conventional combustion engine. Generally, an electric-vehicle battery, EVB, or traction battery is a battery used to power the propulsion of battery electric vehicles, BEVs. Electric-vehicle batteries differ from starting, lighting, and ignition batteries in that they are designed to provide power for sustained periods of time. A rechargeable or secondary battery differs from a primary battery in that it is designed to be repeatedly charged and discharged, while the latter is designed to provide only an irreversible conversion of chemical to electrical energy. Low-capacity rechargeable batteries are used as a power supplies for small electronic devices, such as cellular phones, notebook computers and camcorders, while high-capacity rechargeable batteries are used as a power supplies for electric and hybrid vehicles and the like.

Generally, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, such as cylindrical or rectangular, may be selected based on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled to each other in series and/or in parallel so as to provide a high density such as for motor driving of a hybrid vehicle. That is, the battery module is formed by interconnecting the electrode terminals of the plurality of unit battery cells in an arrangement of configuration depending on a desired amount of power and in order to realize a high-power rechargeable battery.

Battery modules can be constructed in either a block design or in modular design. In the block design each battery is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage. The battery modules may include submodules with a plurality of stacked battery cells and each stack including cells connected in parallel that are connected in series (*XpYs*) or cells connected in series that are connected in parallel (*XsYp*)*.*

A battery pack is a set of any number of (identical or different) battery modules. The battery modules may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery, battery module and battery pack, such as by protecting the batteries from operating outside their safe operating area, monitoring their states, calculating secondary data, reporting that data, controlling its environment, authenticating it and/or balancing it. For example, the BMS may monitor the state of the battery as represented by voltage (e.g., total voltage of the battery pack or battery modules and/or, voltages of individual cells), temperature (e.g., an average temperature of the battery pack or battery modules, coolant intake temperature, coolant output temperature, and/or temperatures of individual cells), coolant flow (e.g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery, state of health (SOH; a variously-defined measurement of the remaining capacity of the battery as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be distributed, with a BMS board is installed at each cell, with just a single communication cable between the battery and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated in case of over-current, overvoltage (during charging), over-temperature, under-temperature, over-pressure, and ground fault or leakage current detection. The BMS may prevent operation outside the battery's safe operating area by including an internal switch (such as a relay or solid-state device) which is opened if the battery is operated outside its safe operating area, requesting the devices to which the battery is connected to reduce or even terminate using the battery, and actively controlling the environment, such as through heaters, fans, air conditioning or liquid cooling.

Static control of battery power output and charging may not be sufficient to meet the dynamic power demands of various electrical consumers connected to the battery system. Thus, steady exchange of information between the battery system and the controllers of the electrical consumers may be employed. This information may include the battery system's actual state of charge (SoC), potential electrical performance, charging ability and internal resistance as well as actual or predicted power demands or surpluses of the consumers. Therefore, battery systems may include a battery management system, BMS, for obtaining and processing such information on a system level and may also include a plurality of battery module managers (BMMs), which are part of the system's battery modules and obtain and process relevant information on a module level. The BMS measures the system voltage, the system current, the local temperature at different places inside the system housing, and the insulation resistance between live components and the system housing. While, the BMMs may measure the individual cell voltages and temperatures of the battery cells in a battery module.

The BMS/BMM or also called battery management unit (BMU) is provided to manage the battery pack, such as by protecting the battery from operating outside its safe operating area (or safe operating parameters), monitoring its state, calculating secondary data, reporting that data, controlling its environment, authenticating it and/or balancing it.

In order to manage or control the battery cells in the battery module or pack, several types of interconnects are necessary. A first type of interconnects is so called busbars which connect two or more terminals of battery cells in order to provide a parallel or serial configuration of the cells. Due to their nature of providing current from/to the cells, busbars are solid and suitable for conducting high currents. Busbars may have a stripe-like shape with a large surface area. The large surface area can carry substantial electric currents. In most applications, they are passive components which can be fitted in even very small and cramped installation spaces but optionally they may also be active components.

A second type of interconnects relates to signal lines or wires which are used to transfer electrical information of a cell or sub-module to the BMS/BMU. Due to their nature of carrying signals, those lines may be flexible, i.e. implemented as a flexible interconnect, e.g. a flexible printed circuit (FPC). Flexible interconnects, e.g. FPCs, are used inside the battery module to connect battery cell poles with the battery management unit. The flexible interconnect may extend over the bus bars and, in this case, requires very smooth edges and surface of the bus bars, which is difficult or impossible to realize and check. A flexible interconnect may be formed as a stack-up of an isolating base material, a copper layer, out of which multiple conducting traces or signal lines may be formed, and an isolating cover layer. While the material of the base and the cover layer have very good isolating properties, they don't need to be very thick to fulfill their purpose as isolation. Their thickness ranges in the tens of micrometers. This isolating cover layer may be a thin layer of an insulating material, e.g. polyimide (PI), which is mechanically durable. Even though the material is durable from a mechanical point of view, because of this small thickness it needs to be protected from hazards, e.g. sharp edges, rough surfaces, stress and so on. In other words, this durability is limited by the thickness of the layer, i.e. a very thin layer of only single digit micrometer thickness would be fragile. Due to the desire to monitor the cell terminals and the generally high number of cells, the flexible interconnect may have a quite high number of conducting traces, wherein each trace is connected to a cell terminal or a busbar. Or a cell terminal may be connected to a busbar, which then has the same potential for all connected cell terminals. In this sense, it might be sufficient to connect the flexible interconnect to busbars, in order to obtain the potential for the cell terminals. If all potentials of all cell terminals are known, the voltage of each cell is known too.

When a flexible interconnect is used for measuring/balancing cell voltages it mechanically interconnects battery cells or busbars. Mainly due to aging, cells are swelling and thus need to be able to expand in size. This variation of size needs to be considered when designing the flexible interconnect. It needs to be able to compensate for changes in distance between two fixation points. In other words, the volume of the package of one battery cell may increase, which causes movement of a single battery cell relative to another adjacent battery cell. Additionally, movement between battery cells may be induced due to vibrations, depending of the use case of the battery module, e.g. when used in a vehicle. Therefore, since flexible interconnects usually are arranged on top of the busbars, a cell swelling needs to be taken into account.

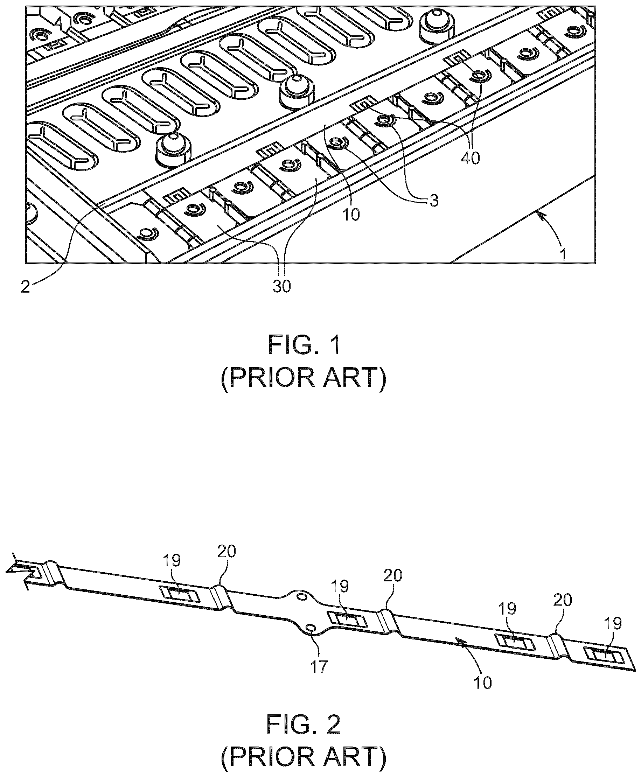

This can be accomplished by different methods. Compensating for length changes by using excess length and forming a wave in z-direction results in difficult assembly. Creating 2D-shapes for each single interface creates more waste and cannot be placed as precisely. In the prior art, this flexibility was realized by the usage of Ω-shapes in z-direction, i.e. vertical direction of the flexible interconnect, of which an example is shown in Fig. 2. For example, Fig. 2 is a typical implementation of a flexible interconnect, showing its top surface in a perspective view, according to prior art. For example, the protrusions in vertical direction are easy to recognize, which act as the above-mentioned Ω-shapes in z-direction. In the middle of the flexible interconnect, extending longitudinally, pad mounting portions for pads or tabs may be provided. This design is very difficult in production. It is impossible to position the tabs, which are used for connecting a flexible interconnect to a busbar, with good accuracy at the dedicated places. The waves or Ω-shapes itself are relaxed after the flexible interconnect production and are usually delivered to the pack assembly in a completely flat condition. So that a second manual placement was the only possible solution with the risk of flexible interconnect damage by pressing them and scratching over sharp edges of the bus bars. Additional plastic parts were necessary to be designed and produced for the assembly process. The flexible interconnect after fixation of welding points was always in stress condition. Even though there is a need for automatic assembly of flexible interconnects by means of robot-arm, this is impossible in case of Ω-shapes.

US 2012/0231638 A1 discloses a structure as described above, i.e. a flexible interconnect with a vertical deflection portion in the longitudinal direction of the flexible interconnect. The busbars are connected to the flexible interconnect by intermediate connectors, so that the busbars and the flexible interconnect are spaced apart.

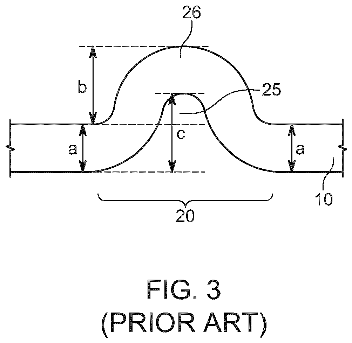

An alternative to the Ω-shape in Z-direction is to create a flat double S-shape, as e.g. shown in Fig 3. Fig. 3 is a top view of a flexible interconnect according to another embodiment in prior art. Instead of the Ω-shapes in z-direction of Fig. 2, the stress relief section is flat and does not extend in z-direction, but forms a double S-shape in the plane of the flexible interconnect. However, the S-shape would require increasing the width of the flexible interconnect twice. What would require twice more space in the battery module, i.e. battery pack and more cut-off material during production. More cut off material refers to that the flexible interconnect is usually formed from a single piece of material, and if the final shape of the flexible interconnect has a certain width, the raw material must have at least the same width. Consequently, large portions of the raw material would be cut off, and just be waste.

Another related prior art document is CN 218242186 U, which discloses a battery module with busbars, a circuit board and connectors connecting the circuit board with the busbars. This design mounts all connectors separately on the circuit board, which is located in the middle on the upper side of the battery module. For example, the connectors have a buffer section disclosing weight reducing holes, which decrease the bending strength, compressive strength and tensile strength and thereby allow deformation, which has a good buffering effect. For this buffering sections, an S-shape, an Ω-shape and a Z-shape are disclosed. However, all of the shapes significantly increase the width of the structure, which brings about the problems mentioned above like increased space requirements and more cut off.

### Summary of Invention

The object of the invention is to provide a more reliable and compact battery cell contact structure. Further, automatic assembly shall be possible and waste, and thus costs, should be reduced. This object is solved by implementing by providing a planar stress relief section. Further, the width of the flexible interconnect is normal, i.e., not or not considerably enlarged. Additionally, cost-effective material usage is achieved by less cut off material.

The invention is defined by the appended claims. The description that follows is subjected to this limitation. Any disclosure lying outside the scope of the claims is only intended for illustrative as well as comparative purposes.

The general inventive concept and preferred embodiments will be described in detail below, in the section "Detailed Description of the Invention" and "General Concept".

According to a first aspect of the disclosure, the battery module includes a plurality of battery cells stacked along a longitudinal direction and a flexible interconnect for providing electrical information of the plurality of battery cells to a battery management unit. The flexible interconnect extends along the longitudinal direction and is affixed to at least one battery cell. Further, the flexible interconnect includes at least one stress relief section extending along the longitudinal direction of the flexible interconnect.. The longitudinal direction of the flexible interconnect indicates the same direction as the longitudinal direction of the stacked battery cells. Additionally, the stress relief section includes at least one cutout extending along the longitudinal direction of the flexible interconnect, and a plurality of interconnect traces divided from each other by the at least one non-linear cutout. Divided means that the interconnecting traces are separated from each other by a gap or void. In addition, the plurality of interconnect traces include a first peripheric interconnect trace forming a recessed portion and a second peripheric interconnect trace, opposite to the first interconnect trace, forming a protruding portion. Peripheric may be further described as lying at an edge, wherein the edge extends in the longitudinal direction of the flexible interconnect. Moreover, a height of the protruding portion in the stress relief section is not larger than a width of the flexible interconnect neighboring the stress relief section. Neighboring may in other words be described as directly next to each other.

According to another aspect of the present disclosure, the at least one stress relief section is planar. Planar may in other words ne described as that the vertical extension of the material of the flexible interconnect is equal to the thickness of the material. Or, the material is not deformed in its plane.

According to another aspect of the present disclosure, the at least one cutout is non-linear.

Such a flexible interconnect can be assembled by robot arms and does not require any special packaging during transport. It further provides more mechanical stability compared to mounting each tab separately distanced from a flexible interconnect and thus can be placed more precisely. Additionally, this battery module allows a relative extension between solid parts of the flexible interconnect and a flat design at the same time, by use of the planar stress relief section with non-linear cutouts.

By limiting the height to the width, the mechanical stability of the flexible interconnect is ensured, while still maintaining the desired flexibility in longitudinal direction of the flexible interconnect. Further, the size of the interconnect in the width direction is not considerably increased.

Optionally, the height of the protruding portion in the stress relief section is not larger than a width of one interconnect trace.

By restricting the height, the flexible interconnect can be implemented in a very compact manner.

In a preferred embodiment the flexible interconnect is linear.

A linear shape of the flexible interconnect ensures efficient direct connection of all battery cells.

Further optionally, wherein the stress relief section is axial-symmetric with regard to an axis perpendicular to the longitudinal direction through the center point of the stress relief section.

A symmetric shape ensures a consistent deformation. Thereby, the formation of weak spots, which might cause breakage after excessive stress and/or deformation can be avoided.

According to another embodiment, at least two of the interconnect traces have an identical width.

A consistent width of the interconnect traces is beneficial not only for mechanical stability, but also for ease of production. Additionally, when a plurality of conductor lines is present, they can be distributed uniformly among the interconnect traces.

According to another embodiment of the present disclosure, the stress relief section includes at least two non-linear cutouts with an identical width.

The cutouts are beneficial for the deformation capability of the flexible interconnect, i.e., the stress relief section. For example, since every interconnect trace deforms, the non-linear cutouts ensure that the deformation is not hindered. Thereby, they also ensure that interconnect traces do not touch each other when deformed. When the non-linear cutouts have an identical width, manufacturing is easier, since they can be formed by the same tool.

Optionally, the flexible interconnect includes at least one conductor line.

According to another embodiment, each stress relief section, each interconnect trace, includes at least one conductor line.

When each interconnect trace includes one conductor line, the distribution of the conductor lines on the flexible interconnect is particularly easy. Further, all conductor lines experience the same stress during deformation.

According to another embodiment, each non-linear cutout is meandering or has a wave-like, an Ω-like a v-like or a w-like shape.

All of the mentioned shapes have a particularly good flexibility. Further, they have in common that both of their ends lie on the same line parallel to the longitudinal direction, so that they do not alter the linear shape of the flexible interconnect.

Optionally, the flexible interconnect is formed as a flexible printed circuit.

According to an embodiment, the height of the protruding portion in the stress relief section is not larger than the width of one interconnect trace.

Limiting the width of the protrusion is beneficial for a compact flexible interconnect design. A compact design avoids cut off of material and is thus economical regarding resources but also from a manufacturing point of view.

According to a further aspect of the present disclosure, a battery pack includes a plurality of the battery modules as mentioned above.

Further optionally, the shapes of neighbouring non-linear cutouts are not identical but similar.

Thereby, deformation particularities of the interconnect traces can be adopted for.

According to another embodiment, the flexible interconnect is connected to at least one connection tab which is connected to one of the conductor lines in a one to one relationship, wherein each connection tab is electrically connected to at least one of the pluralities of battery cells.

The connection tabs are convenient connections means. Those tabs enable favourable installation properties for the flexible interconnect in the battery module.

According to another embodiment, the flexible interconnect has at least two connection tabs, and the stress relief section extends along the whole distance between the two connection tabs.

When the whole space between two tabs is used for stress relief, the stress concentration, i.e. the deformation per unit of length is low. Accordingly, durability is improved.

Optionally, a plurality of meandering portions is formed between two connection tabs.

Similarly, then, the stress concentration, i.e. the deformation per unit of length is low. Accordingly, durability is improved.

According to another embodiment, the flexible interconnect includes at least one pad mounting portion for mounting a pad, which is connected the battery cell, wherein the pad mounting portion is positioned outside the stress relief section at an edge of the flexible interconnect extending in the longitudinal direction of the flexible interconnect.

Compared to, e.g. connecting the pads to the middle of the flexible interconnect, connecting them to the edges introduces another degree of flexibility, while maintaining the compact design of the whole interconnect structure. Another degree of flexibility refers to that, e.g. when the distance between two adjacent battery cells increases due to, e.g. swelling, the edge, on which the pad is installed will be under tension. The opposite edge, at a distance from the pads, will be under compressive stress. Thereby, the flexible interconnect itself may act as a stress absorption and/or relief means. Further, the action of the stress relieve section can be influenced by the placement of the pad mounting portion, because the angle, at which a longitudinal force acts on the stress relief section can be influenced.

According to another aspect of the present disclosure, the vertical extension of the flexible interconnect in the stress relief section including the protruding portion and the recessed portion is width plus height, which sum is less than two times width.

Restricting the width of the flexible interconnect in the stress relive section is beneficial for a compact design of the flexible interconnect.

According to another embodiment, the variation in length of the flexible interconnect can be compensated for by the interconnect traces, which cause a change in length of the stress relief section.

Optionally, the flexible interconnect is stacked on top of a busbar and/or a battery cell terminal.

Stacking the flexible interconnect on top of the contacts to be connected ensures short signal runtimes. Further, it favours a compact design. When the distances to be connected are short, less material is needed for producing the connection structure.

Another implementation of the present disclosure refers to a method for optimizing the structure of a stress relief section of a flexible interconnect in a battery module, as mentioned above. The number of non-linear cutouts and the minimum height of the protruding portion are calculated based on design rules regarding the minimum distance from a copper trace for transporting the electrical information of the battery terminals to an outline. The design rules for example refer to design rules of CAD software for designing battery modules and/or electrical interconnect structures of battery modules. Further, the copper trace may also be referred to as a signal line. The outline refers to the outer contour of the flexible interconnect, for example in a main section or for interconnect traces.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
Fig. 1 illustrates a schematic partial perspective view of a battery module according to prior art.
Fig. 2 illustrates a schematic partial perspective view of a flexible interconnect according to prior art.
Fig. 3 illustrates a top view of another flexible interconnect according to prior art.
Fig. 4 illustrates a top view of a flexible interconnect according to an embodiment of the invention.
Fig. 5 illustrates a top view of the same flexible interconnect of Fig. 4, showing details of a stress relief section according to an embodiment of the invention.
Fig. 6 illustrates a top view of another embodiment of a stress relief section according to the invention.
Fig. 7 illustrates a top view of another embodiment of a stress relief section according to the invention.

### Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will also be understood that when a film, a region, or an element is referred to as being "above" or "on" another film, region, or element, it can be directly on the other film, region, or element, or intervening films, regions, or elements may also be present.

The electrical connections or interconnections described herein may be realized by conducting elements, e.g. on a PCB or another kind of circuit carrier. The conducting elements may comprise metallization, e.g. surface metallizations and/or pins, and/or may comprise conductive polymers or ceramics.

In the drawings, the sizes of elements may be exaggerated for clarity. For example, in the drawings, the size or thickness of each element may be arbitrarily shown for illustrative purposes, and thus the embodiments of the present invention should not be construed as being limited thereto.

### General Concept

According to one aspect of the present disclosure, a battery module includes a plurality of battery cells and a flexible interconnect for providing electrical information of the plurality of battery cells to a battery management unit. The flexible interconnect has an elongated shape in the longitudinal direction of the battery module which defines the longitudinal direction of the flexible interconnect. Elongated in this respect is an element having a width and a length, in which the length is much larger than the width for example double the size, ten times the size, or 20 times the size of the width. The flexible interconnect is affixed to at least one battery cell. Further, the flexible interconnect includes at least one planar stress relief section extending along the longitudinal direction of the battery module. Additionally, at least one planar stress relief section includes at least one non-linear cutout extending along the longitudinal direction of the flexible interconnect. At least one cutout refers to the creation of a longitudinal hole, beginning from a top-side and ending at a bottom side, i.e. at least one cutout is a through-hole. Non-linear for example means that two points "A" and "B" are not connected by a straight line, but in an indirect manner. The connection may be curved, or may include edges. The points may be connected by two intersecting lines. A plurality of interconnect traces is divided from each other by the at least one non-linear cutout. Next to each cutout, two interconnect traces are formed.

In other words, the present disclosure relates to a new form of a relaxing expandable element between solid flexible interconnect pieces by means of cutouts or slots. This is achieved by creating, e.g., several parallel double S-shapes of smaller width compared to the normal, e.g. average width of the flexible interconnect, to allow relative longitudinal extension between solid parts of the flexible interconnect and a flat design at the same time.

Thereby, a particularly compact design for the flexible interconnect is realized, which is slim, i.e. its width is narrow, and which is flexible in longitudinal direction. Flexible for example means that it can be compressed and stretched. Compression might also be called compressive stress. Stretching or expanding might also be called tensile stress. Compression and tensioning might occur repeatedly.

### Specific Embodiments

In this section, specific embodiments illustrated in the drawings shall be described in detail.

Fig. 1 illustrates a battery module 1 of the prior art. Fig. 1 is a partial perspective view of an upper surface of the battery module 1 in which a plurality of battery cells 2 are arranged in parallel along a longitudinal direction of the battery module 1. The plurality of battery cells 2 are connected to each other by a busbar 30. The busbar 30 connects terminals 3 of battery cells 2. For example, two neighbouring battery cells 2 are connected by the busbar 30. Here, a first part of the busbar 30 extends along the longitudinal direction of the battery cell 2, on top of and parallel to the battery cell 2, wherein two of such first parts are connected to one busbar 30. I.e., the busbar 30 extends in the stacking direction of the battery cells. Accordingly, the lines labelled 30 indicates the first two busbars in Fig. 1. The busbar 30 may have a planar structure. On top of the busbar 30, a pad 40 is arranged, which is connected to a flexible interconnect 10. The flexible interconnect 10 extends along the battery module 1 in the longitudinal direction. As an example, it can be seen that six busbars 30 each have one pad 20 which are all connected to the same flexible interconnect 10. This means in turn that the flexible interconnect 10 has at least six signal lines. In this embodiment, the number of signal lines formed on the flexible interconnect 10 is equal to the number of busbars 30 connected to the flexible interconnect 10.

Fig. 2 is a perspective view of an upper surface of a flexible interconnect of a prior art battery cell contacting structure. In fact, Fig. 2 shows a flexible interconnect 10, an FPC 12, according to a prior art design. The flexible interconnect 10 may include mounting holes 17 on its sides with a margin for adjustment when placing the flexible interconnect 10. In the middle of the flexible interconnect 10, pad mounting portions 19 may be provided. In this example, the flexible interconnect 10 is connected to a busbar 30 or a cell terminal 3 at the pad mounting portions 19 by a pad or tabs (not shown). signal lines (not shown) for transferring the electrical information of the battery cells 2 to a battery management system (not shown) are located on the bottom of the flexible interconnect 10. In this design, stress relief sections 20 are formed, which extend in vertical direction, i.e., the flexible interconnect 10 is not flat. It can further be seen that at least one stress relief portion 20 may be located between two pad mounting portions 19.

Fig. 3 is a partial top view of a stress relief section 20 of an upper surface of a flexible interconnect 10 in a flat design according to prior art. It is shown that the flexible interconnect 10 has a width "a" at the very left and right, and in the stress relief section 20, has a protruding portion 26, protruding by a height "b", and a recessed portion 25 on the opposite edge of the flexible interconnect 10 in the stress relief section 20. Throughout this disclosure, the height "b" is defined and/or measured from an outer edge of the flexible interconnect 10, wherein the outer edge is parallel to the longitudinal direction of extension of the flexible interconnect 10, to a tangent line parallel to an outer edge of the protruding portion 26, and distanced from the outer edge of the flexible interconnect 10. In this prior art embodiment, the height "b" of the protruding portion is significant, meaning that the value of the height "b" of the protruding portion is at least close to the width "a" of the flexible interconnect 10 or much larger than the width "a" of the flexible interconnect 10. This results in a depth "c" of the recessed portion 25 which clearly exceeds the width "a" of the flexible interconnect 10. In other words, an inflection point of the recessed portion 25 exceeds the width "a" of the flexible interconnect. Therefore, this embodiment causes a significant increase in overall width of the flexible interconnect 10, the overall width being width "a" plus height "b". Therefore, the production of this flexible interconnect 10 according to Fig. 3 requires cutoff of significant material on the left and right side of the stress relief section 20, since the flexible interconnect 10 is usually formed integrally out of one piece.

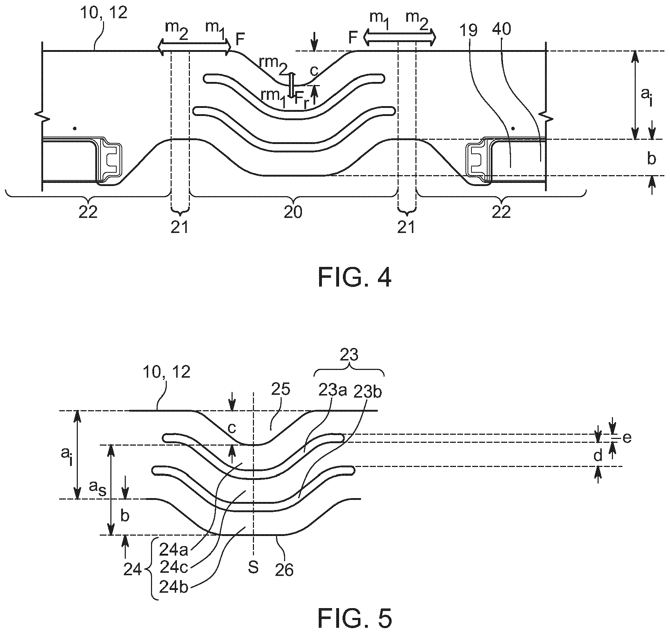

Fig. 4 and Fig. 5 are top views illustrating the upper side of an embodiment of a flexible interconnect 10, for example an FPC 12, according to the present disclosure. For illustrative purposes, the following disclosure might jump in between Fig. 4 and Fig. 5, which are separated to ensure clarity. Firstly, referring to Fig. 4 illustrating the concept of a non-limiting example of the present disclosure, the flexible interconnect 10 may be linear and includes a stress relief section 20, which may also be called a stress accommodation section. The stress relief section 20 includes a structure which is capable of absorbing stress. The structure may include non-linear cutouts 23 and interconnect traces 24, which will be described in detail below. On both ends of the stress relief section 20 may be main sections 21 of the flexible interconnect 10. The main section 21 has a width "aᵢ" and, optionally, extends in longitudinal direction of the flexible interconnect 10. A width "aₛ" of the flexible interconnect 10 in the stress relief section 20 is not larger than or equal to the width "aᵢ" of the flexible interconnect 10 in the main section 21. When referring to the width "aₛ" of the stress relief section 20, this does not include the void or depth "c" formed by the recessed portion 25 or the height "b" of the protruding portion 26. The stress relief section 20 is terminated by outer interconnect traces 24a,24b, for example at least two outer interconnect traces 24a,24b, which are described later. The longitudinal direction of the flexible interconnect 10 is equivalent to the stacking direction of the battery cells 2, but is not limited thereto. The width "aᵢ" and/or "aₛ" may be in a range between 2 to 20 mm, 4 to 15 mm, or 6 to 10 mm. For example, the width "aᵢ" and/or "aₛ" may depend on the number of battery cells 2, i.e., on the number of busbars 30 which have to be connected by the flexible interconnect 10. A width of 2 mm is sufficient for small battery modules. A width of 20 mm is sufficient for large-scale applications. Even though the main section 21 in this embodiment is shown to be short, the disclosure is not limited thereto, and the main section 21 may span a longer distance than the stress relief section 20 and/or multiples thereof. Adjacent to the main section 21 may be a pad mounting section 22, where a pad 40 is mounted to the flexible interconnect 10 at the pad mounting portion 19, connecting the flexible interconnect 10 to the busbar 30 by the pad 40. In this non-limiting example, the pad mounting section 22 has a larger width than the main section 21, which is, however, optional. The pad mounting section 22 may as well have the same width as the main section 21 or the same width as the stress relief section 20. Optionally, in the case that the pad mounting portion 22 is directly attached to the stress relief section 20, the main section 21 may also be a part of the flexible interconnect 10 on a side of a pad mounting structure facing away from the stress relief section 20. In other words, the "main section" is the section of the flexible interconnect 10 in which the flexible interconnect 10 extends along the longitudinal direction with its predominant width, without any indentations or protrusions. The flexible interconnect 10 has the form of a rectangle in the main section 21. The predominant width is the width of the flexible interconnect 10 which it has in its section different from the pad mounting portion 22 and different from the stress relief section 20. For example, more than 80% of the flexible interconnect 10 is formed with the predominant width.

Alternatively, the stress relief section 20 may also be described as being displaced with respect to the neighbouring sections, i.e. the main section 21 and/or the pad mounting section 22. Displaced refers to that with respect to the longitudinal direction of the flexible interconnect 10, the stress relief section 20 is moved away from the original longitudinal direction in the same plane as the flexible interconnect 20. In other words, the stress relief section 20 is moved perpendicular to the longitudinal direction of the flexible interconnect 10. However, the flexible interconnect 20 remains continuous.

Fig. 5 illustrates the stress relief section 20 in detail. In this non-limiting example, the stress relief section 20 includes two non-linear cutouts 23 extending along the longitudinal direction of the flexible interconnect 10. The longitudinal extension of the non-linear cutout 23 is non-linear, which means that two points "A" and "B" are not connected by a straight line. In other words, they are connected in an indirect manner. The connection may be curved and may be referred to as meandering or may include two or more straight lines with intersection points therebetween. Meandering riverbeds are common in nature and form a well-known shape. Optionally, the shape of the stress relief section 20 may also be referred to as an Ω-shape, wherein the legs of the Ω are partly pulled apart. While the Ω-shape is originally almost circular, when the lower flat straight portions are pulled apart, the circular shape is flattened and may form the shape as depicted in Fig. 4 and 5. The non-linear cutouts 23 have a width "e". The stress relief section 20 may have at least two non-linear cutouts 23. In some embodiment, the width "e" of each non-linear cutout 23 is identical. In another embodiment, the width "e" of at least two non-linear cutouts 23 is identical. The width "e" may be constant throughout the length of the non-linear cutout 23 or may be variable. One non-linear cutout 23 separates the flexible interconnect 10 into at least two interconnect traces 24. For example, the stress relief section 20 has two outer interconnect traces 24a,24b on its edges. The outer outline of a first outer interconnect trace 24a forms a recessed portion 25. The outer outline of a second outer interconnect trace 24b, opposite to the first outer interconnect trace 24a, forms a protruding portion 26. In this non-limiting embodiment, three interconnect traces 24 are formed by two non-linear cutouts 23. In other words, n non-linear cutouts 23 form n+1 interconnect traces 24. The interconnect traces 24 may have a width "d". For example, at least two of the interconnect traces 24 have an identical width "d". Optionally, all interconnect traces 24 may have the same width "d", or may have a different width or a changing width. E.g., the outer interconnect trace 24a,24b may have the largest width and each inner interconnect traces 24c may have a smaller width. Contrary thereto, the outer interconnect trace 24a,24b may have the smallest width and each inner interconnect traces 24c may have a larger width. This would yield flexibility towards the interconnect traces 24 with smaller thickness. The width "d" may be in a range between 1 to 10 mm, 2 to 8 mm or 3 to 5 mm. A thickness of 1 mm provides sufficient strength and is most flexible. On the other end of the range, 10 mm provides very good strength while still being flexible enough for achieving the positive effects of the present disclosure. In the middle of the stress relief section 20 is provided with an axis of symmetry "S". The axis of symmetry "S" may be axial-symmetric with regard to an axis perpendicular to the longitudinal direction through the center point of the stress relief section 20. The non-linear cutout 23 may have an s-shape. Since the s-shape extends on both directions of the axis of symmetry "S", this cutout may also be referred to as a double-s-shape. For example, it can be seen that not only the non-linear cutouts 23, but also the interconnect traces 24 may have a double-s-shape. Optionally, the shapes of the non-linear cutouts 23 and/or the shapes of the interconnect traces 24 extend parallel to each other. Even though they may extend parallel to each other, they may be of different size and/or length can be seen in Fig. 5, where a first outer non-linear cutout 23a is, in longitudinal direction of the flexible interconnect 10, shorter than a second outer non-linear cutout 23b. On the other hand, the non-linear cutouts 23 may all or partly have the same length. Furthermore, as shown in Fig. 4 and Fig.5, it can be seen that the second outer non-linear cutout 23b may have, in the vicinity of the axis of symmetry "S", a linear portion which is longer than the same linear portion of the first outer non-linear cutout 23a.

Since the non-linear cutout 23 extends non-linearly, consequently, a recessed portion 25 and a protruding portion 26 are formed in the flexible interconnect 10. Both portions have the function that when a force F acts in longitudinal direction (cf. longitudinal arrows in Fig. 4) on the outer ends of the stress relief section 20, or optionally, the outer ends of the flexible interconnect 10, this tension is translated into a deformation of the stress relief section 20. This means that a force Fᵣ causes an intended deformation of the stress relief section 20. In other words, stress is concentrated in this stress relief section 20 and cannot act on other parts of the interconnect structure in an uncontrolled manner. E.g., for compressive stress, which might be caused by movement m₁ of both end of the stress relief section 20, one or more interconnecting traces 24 deform, e.g. by a reactive movement rm₁, and the longitudinal ends of the stress relief section 20 move towards each other. Then, the stress relief section 20 is compressed, i.e. the height "b" of the protruding portion 26 may become larger. For the opposite case, i.e. tensile stress, which might be caused by movement m₂, the interconnecting traces 24 deform, e.g. by a reactive movement rm₂, and the longitudinal ends of the stress relief section 20 move away from each other. Then, the stress relief section 20 is flattened, i.e. the height "b" of the protruding portion 26 may become smaller. All of the deformations occur in the same plane as the plane which the flexible interconnect 10 extends in. Accordingly, the deformation in vertical direction of the flexible interconnect 10 is minimal, e.g., zero. According to the non-limiting embodiment in Fig. 5, the recessed portion 25 is formed next to the first outer interconnect trace 24a. Optionally, the recessed portion 25 may have a rounded shape, for example a round or an oval shape. The recessed portion 25 has a depth "c". The depth "c" may be smaller than the width of the flexible interconnect "aᵢ". Optionally, the width "c" may be between a,/2 and the width "d" of the interconnect trace 24. On the opposite side of the recessed portion 25, the protruding portion 26 is formed. The protruding portion 26 has the height "b". In one embodiment, the height "b" and the depth "c" may be identical. The recessed portion 25 and the protruding portion 26 refer to portions of the flexible interconnect 10 itself, i.e. define the outer shape of the flexible interconnect 10. According to an embodiment of the present invention, the width "aₛ" of the flexible interconnect 10 in the stress relief section 20 is not larger than or equal to the width "aᵢ" of the flexible interconnect 10 in the main section 21. The width "a_{S}" of the flexible interconnect 10 in the stress relief section 20 may be measured by taking an orthogonal onto a tangent along the non-linear outer edge of the first outer interconnecting trace 24a to the opposite outer edge of the second outer interconnecting trace 24b. In the stress relief section 20, the overall vertical expansion of the flexible interconnect 10 in the stress relief section 20 is, when taking the outer edge of the flexible interconnect 10 on the side of the recessed portion 25 as the baseline, i.e. zero, width "aᵢ" plus height "b", wherein width "aᵢ" refers to the width of the flexible interconnect 10, in the main section 21, i.e. the predominant width, and height "b" refers to the vertical expansion of the protruding potion 26, which exceeds the width "aᵢ" of the flexible interconnect 10 in the main section 21. Optionally, the height "b" of the protruding portion 26 may be equal to the width "d" of the interconnect trace 24. In some embodiments, the height "b" of the protruding portion 26 may be smaller than the width "d" of the interconnect trace 24. In other words, the height "b" of the protruding portion 26 in the stress relief section 20 is not larger than the width "d" of one interconnect trace 24. The smaller the height "b" of the protruding portion 26, the more compact will be the whole flexible interconnect 10. For example, the lower the height "b" of the protruding portion 26, the lower the required amount of material to be cut off. On the other hand, the recessed portion 25 does not directly influence the height "b" of the protruding portion 26, but only defines the depth "c". Therefore, in some embodiments, the width aₛ of the flexible interconnect 10 in the stress relief section 20 can be made smaller than width "aᵢ" of the flexible interconnect 10, if the height "b" of the protruding portion 26 is smaller than depth "c". The main criteria are that the width "aₛ" of the stress relief section 20 is sufficient to accommodate all signal lines. Then, the width "aₛ" of the stress relief section 20 may be smaller than the width "aᵢ" of the flexible interconnect 10.

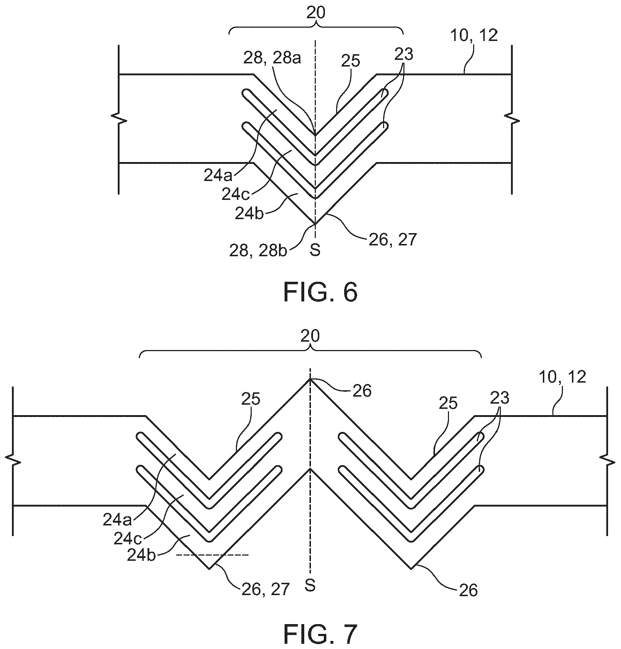

Fig. 6 illustrates another embodiment of the present disclosure. For example, Fig. 6 is a top view of a stress relief section 20, similar to Fig. 5. In this non-restricting embodiment, a v-shape is used in the stress relief section 20. The v-shape might have a corner 28 in the axis of symmetry "S". For example, a non-linear cutout 23 as well as a interconnect trace 24 may have such the corner 28. The corner 28 may be sharp or round or any shape in between. The comer 28 in the recessed portion 25 might be referred to as an inner corner 28a. Similarly, the corner 28 in the protruding portion 26 might be referred to as an outer corner 28b. Further, the definitions regarding the stress relief section 20, the main section 21 and the pad mounting section 22 of the preceding embodiments apply accordingly. For example, the definitions regarding the height "b" of the protruding portion 26 apply accordingly. Even though a second outer interconnect trace 24b forming the protruding portion 26 has a sharp tip 27 or corner 28 here, this tip 27 or corner 28 might be cut off (cf. Fig. 7), or rounded. Thereby, the height "b" of the protruding portion 26 may be reduced.

Fig. 7 is a top view of another embodiment of the present disclosure similar to the embodiment in Fig. 6. In this non-restricting embodiment, a w-shape is used in a stress relief section 20. The w-shape might be formed of two v-shapes as described above. In this case, the axis of symmetry "S" is located in the middle of the w-shape. The w-shape may have only two protruding portions 26 on the lower side w-shape Optionally, the w-shape may have one additional protruding portions 26 in the middle and on the upper side of w-shape. In this case, the may be a total of three protruding portions 28. From this embodiment, it becomes clear that a non-linear cutout 23 may not be continuous throughout the whole stress relief section 20, but may be intermittent. Optionally, the non-linear cutout 23 may be continuous even through longer shapes, i.e. the whole w-shape.

It is explicitly noted that some of the features indicated by numerals mentioned above are omitted in other sections of the drawings, in order to improve readability. However, it is clear to the skilled in the art that, e.g. the cut off corner in Fig. 7 may be applied to all other corners of the present disclosure. Further, it should be kept in mind that many other shapes can achieve the same functionality, i.e. the stress relief section 20 is not limited to the shapes disclosed in Fig. 5-7. E.g., other shapes with an axis of symmetry, or even shapes without an axis of symmetry are applicable. For example, any concatenation of simple basic shapes, or the shapes disclosed here, would be viable.

When comparing the embodiments of Fig. 5 to Fig. 7, the following differences become apparent. The stress relief section 20, i.e. the non-linear cutout 23 and/or the interconnect trace 24 of the embodiment in Fig. 5 have a rounded shape while the shapes of Fig. 6 and 7 are edged. The rounded shape might distribute the longitudinal stress in a more distributed manner. The edged shapes of Fig. 5 and 6 have linear portions and cornered portions, which might be easier to manufacture. Comparing the embodiments of Fig. 6 and 7, the v-shape is more compact. On the other hand, the w-shape has the option to move the protruding portion 26 in the middle vertically. Thereby, the deformation properties of the stress relief section 20 can be adjusted. Furthermore, length of the non-linear cutout may be changed in all embodiments.

For all of the embodiments of the present disclosure, for example the embodiments mentioned above, conductor lines may pass through the flexible interconnect 10 in longitudinal direction. For example, the flexible interconnect 10 includes at least one conductor line. One conductor line connects one pad 40 with the other end of the flexible interconnect 10, at which a BMU/BMS (illustration omitted) may be located. When the flexible interconnect 10 includes a plurality of conductor lines, the conductor lines may be distributed between the interconnect traces 24. E.g., each stress relief section 20, each interconnect trace 24 may include at least one conductor line. Optionally, one interconnect trace 24 may include a plurality of conductor line. In this case, the distances between individual conductor lines have to be considered when defining the width "d" of each interconnecting trace 24. Similarly, when defining the width "e" of a non-linear cutout 23, it has to be considered up to which degree deformations of the interconnect traces 24 in the stress relief section 20 are possible, so that the interconnecting traces 24 do not touch. Optionally, they might touch, but then it has to be assured that the conducting lines do not come too close and, for example, do not touch each other. Further, it is clear to the skilled in the art that all width and measurements referred to in this disclosure are measured in a relaxed state, i.e. not under stress.

### Reference signs

- 1: battery module
- 2: battery cell
- 3: terminal
- 10: flexible interconnect
- 12: flexible printed circuit
- 17: mounting hole;
- 19: pad mounting portion
- 20: stress relief section
- 21: main section
- 22: pad mounting section
- 23: non-linear cutout
- 24: interconnect trace
- 25: recessed portion
- 26: protruding portion
- 27: tip
- 28: corner
- 28a: outer corner
- 28b: inner corner
- 30: busbar
- 40: pad

## Claims

1. A battery module (1) comprising
a plurality of battery cells (2) stacked along a longitudinal direction;
a flexible interconnect (10) for providing electrical information of the plurality of battery cells (2) to a battery management unit, wherein the flexible interconnect (10) extends along the longitudinal direction and is affixed to the plurality of one battery cells (2),
**characterized in that**
the flexible interconnect (10) comprises at least one stress relief section (20) extending along the longitudinal direction of the flexible interconnect (10),
wherein the stress relief section (20) comprises at least one cutout (23) extending along the longitudinal direction of the flexible interconnect (10), and a plurality of interconnect traces (24) divided from each other by the at least one non-linear cutout (23),
wherein the plurality of interconnect traces (24) comprise a first peripheric interconnect trace (24) forming a recessed portion (25) and a second peripheric interconnect trace (24), opposite to the first interconnect trace (24), forming a protruding portion (26), and
wherein a height (b) of the protruding portion (26) in the stress relief section (20) is not larger than a width (aᵢ) of the flexible interconnect (10) neighbouring the stress relief section (20).

2. The battery module (1) according to claim 1, wherein the at least one stress relief section (20) is planar.

3. The battery module (1) according to claim 2, wherein the at least one cutout (23) is non-linear.

4. The battery module (1) according to claim 3, wherein the height (b) of the protruding portion (26) in the stress relief section (20) is not larger than a width (d) of one interconnect trace (24).

5. The battery module (1) according to one of the preceding claims, wherein the width (aᵢ) of the flexible interconnect (10) neighbouring the stress relief section (20) is equal to a width (aₛ) of the flexible interconnect (10) in the stress relief section (20).

6. The battery module (1) according to one of claims 2 to 4, wherein the flexible interconnect (10) further comprises
at least one pad mounting portion (19) for mounting a pad (40), which is connected the battery cell (1), wherein the pad mounting portion (19) is positioned outside the stress relief section (20) at an edge of the flexible interconnect (10) extending in the longitudinal direction of the flexible interconnect (10).

7. The battery module (1) according to one of the preceding claims, wherein the stress relief section (20) is axial-symmetric with regard to an axis perpendicular to the longitudinal direction through the center point of the stress relief section (20).

8. The battery module (1) according to one of the preceding claims, wherein at least two of the interconnect traces (24) have an identical width.

9. The battery module (1) according to one of the preceding claims, wherein the stress relief section (20) comprises at least two non-linear cutouts (23) with an identical width.

10. The battery module (1) according to one of the preceding claims, wherein the flexible interconnect (10) comprises at least one conductor line.

11. The battery module (1) according to one of the preceding claims, wherein each stress relief section (20) comprises at least one conductor line.

12. The battery module (1) according to one of the preceding claims, wherein each interconnect trace (24), comprises at least one conductor line.

13. The battery module (1) according to one of the preceding claims, wherein each non-linear cutout (23) is meandering or has a wave-like, an Ω-like a v-like or a w-like shape.

14. The battery module (1) according to one of the preceding claims, wherein the flexible interconnect (10) is formed as a flexible printed circuit (12).

15. A battery pack comprising a plurality of battery modules (1) according to one of the preceding claims.

## Amended claims

### Amended claims in accordance with Rule 137(2) EPC.

1. A battery module (1) comprising
a plurality of battery cells (2) stacked along a longitudinal direction;
a flexible interconnect (10) for providing electrical information of the plurality of battery cells (2) to a battery management unit, wherein the flexible interconnect (10) extends along the longitudinal direction and is affixed to the plurality of one battery cells (2),
wherein the flexible interconnect (10) comprises at least one planar stress relief section (20) extending along the longitudinal direction of the flexible interconnect (10),
wherein the stress relief section (20) comprises at least one non-linear cutout (23) extending along the longitudinal direction of the flexible interconnect (10), and a plurality of interconnect traces (24) divided from each other by the at least one non-linear cutout (23),
wherein the plurality of interconnect traces (24) comprise a first peripheric interconnect trace (24a) forming a recessed portion (25) and a second peripheric interconnect trace (24b), opposite to the first peripheric interconnect trace (24a), forming a protruding portion (26),
wherein a height (b) of the protruding portion (26) in the stress relief section (20) is not larger than a width (aᵢ) of the flexible interconnect (10) neighbouring the stress relief section (20),
**characterized in that** the height (b) of the protruding portion (26) in the stress relief section (20) is not larger than a width (d) of one interconnect trace (24), and
wherein the plurality of interconnect traces (24) further comprises an inner interconnect trace (24c) with larger width than the first peripheric interconnect trace (24a) and the second peripheric interconnect trace (24b).

2. The battery module (1) according to claim 1, wherein the width (aᵢ) of the flexible interconnect (10) neighbouring the stress relief section (20) is equal to a width (aₛ) of the flexible interconnect (10) in the stress relief section (20).

3. The battery module (1) according to claim 1, wherein the flexible interconnect (10) further comprises
at least one pad mounting portion (19) for mounting a pad (40), which is connected the battery cell (1), wherein the pad mounting portion (19) is positioned outside the stress relief section (20) at an edge of the flexible interconnect (10) extending in the longitudinal direction of the flexible interconnect (10).

4. The battery module (1) according to one of the preceding claims, wherein the stress relief section (20) is axial-symmetric with regard to an axis perpendicular to the longitudinal direction through the center point of the stress relief section (20).

5. The battery module (1) according to one of the preceding claims, wherein at least two of the interconnect traces (24) have an identical width.

6. The battery module (1) according to one of the preceding claims, wherein the stress relief section (20) comprises at least two non-linear cutouts (23) with an identical width.

7. The battery module (1) according to one of the preceding claims, wherein the flexible interconnect (10) comprises at least one conductor line.

8. The battery module (1) according to one of the preceding claims, wherein each stress relief section (20) comprises at least one conductor line.

9. The battery module (1) according to one of the preceding claims, wherein each interconnect trace (24), comprises at least one conductor line.

10. The battery module (1) according to one of the preceding claims, wherein each non-linear cutout (23) is meandering or has a wave-like, an Ω-like a v-like or a w-like shape.

11. The battery module (1) according to one of the preceding claims, wherein the flexible interconnect (10) is formed as a flexible printed circuit (12).

12. A battery pack comprising a plurality of battery modules (1) according to one of the preceding claims.
